Europäisches Patentamt

European Patent Office

Office européen des brevets

(11) Numéro de publication : **0 046 825**
**B1**

# (12) FASCICULE DE BREVET EUROPÉEN

(45) Date de publication du fascicule du brevet :
**28.11.84**

(21) Numéro de dépôt : **80200820.1**

(22) Date de dépôt : **01.09.80**

(51) Int. Cl.³ : **H 01 L 25/14, H 01 L 23/40**

---

(54) **Procédé de fabrication d'un ensemble d'éléments électriques enserrés entre des masses refroidies et ensemble fabriqué selon ce procédé.**

---

(43) Date de publication de la demande :
**10.03.82 Bulletin 82/10**

(45) Mention de la délivrance du brevet :
**28.11.84 Bulletin 84/48**

(84) Etats contractants désignés :
**AT BE CH IT LI LU NL**

(56) Documents cités :
**EP-A- 0 015 488**
**FR-A- 2 324 107**

(73) Titulaire : **ATELIERS DE CONSTRUCTIONS ELECTRI-
QUES DE CHARLEROI (ACEC) Société Anonyme
Avenue Lloyd George 7
B-1050 Bruxelles (BE)**

(72) Inventeur : **Rochet, André
Rue du Brun Chène, 93
B-6100 Mont-sur-Marchienne (BE)**

(74) Mandataire : **Bossard, Franz et al
ACEC - Service des Brevets Boîte Postale 4
B-6000 Charleroi (BE)**

Jouve, 18, rue St-Denis, 75001 Paris, France

## Description

La présente invention a pour objet un procédé de fabrication d'un ensemble d'éléments électriques enserrés entre des masses refroidies et alignés en colonne selon un axe et un ensemble fabriqué selon ce procédé.

De tels ensembles sont courants notamment dans des montages de semi-conducteurs de puissance dont la longévité dépend d'un refroidissement efficace et sûr. Dans ces ensembles connus, les éléments semi-conducteurs sont alignés avec des masses refroidies et forment un empilage cylindrique qui est comprimé entre deux pièces d'extrémité débordant de ladite colonne constituées, par exemple, par des barres transversales ou des étriers, disposées de part et d'autre de l'empilage, reliées entre elles au moyen d'organes de liaison à l'extérieur de ladite colonne. Ces organes de liaison sont constitués, par exemple, par deux tringles, dont au moins une des extrémités est filetée, qui réunissent les deux pièces d'extrémité et dont un serrage convenable et équilibré permet d'engendrer une force de compression assurant un contact sûr et efficace entre les semi-conducteurs et les masses refroidies.

La fabrication de ces montages connus nécessite des précautions très grandes d'isolement et d'équilibrage de serrage des deux pièces d'extrémité, de sorte que cette fabrication est coûteuse. Ces montages connus qui nécessitent des organes de liaison, tels que des tringles en acier à cause des pressions requises entre les éléments électriques et les masses refroidies (3 t et davantage), sont compliqués à réaliser si des différences de tensions considérables existent entre les différents éléments électriques, parce que les distances d'isolement nécessaires conduisent à des encombrements relativement importants.

Il est connu aussi, suivant le brevet FR-A-2 324 107, de fabriquer un ensemble d'éléments électriques enserrés entre des pièces intermédiaires refroidies, déformables élastiquement, alignés en colonne suivant un axe et comprimés selon cet axe. La force de compression est obtenue au moyen de deux pièces d'extrémité équipées d'un ensemble d'organes de serrage axiaux dont font partie les pièces intermédiaires élastiques. Les pièces d'extrémité sont reliées entre elles par un organe de liaison en matière isolante, à l'extérieur de ladite colonne.

Dans l'ensemble suivant ce brevet FR-A-2 324 107, l'assemblage décrit entre les pièces d'extrémité et l'organe de liaison ne permet pas d'atteindre les pressions nécessaires mentionnées ci-dessus. De plus, cet assemblage ne présente pas une robustesse suffisante, si l'ensemble doit être monté sur un châssis tel qu'un véhicule, où il est exposé à des vibrations et secousses violentes.

L'invention a pour but un procédé de fabrication de tels ensembles qui est bon marché et dont les produits sont peu encombrants, parfaits du point de vue de l'isolation et sûrs, même s'ils sont montés sur des véhicules et souffrent des vibrations et secousses du trafic.

Le procédé suivant l'invention est caractérisé en ce qu'on fabrique, selon la revendication 1, des courroies en matière isolante de longueurs sensiblement égales, en ce qu'on relie entre elles les pièces d'extrémité au moyen d'une paire des dites courroies et en ce qu'on tend lesdites courroies en comprimant la colonne au moyen de l'ensemble des organes de serrage équipant les pièces d'extrémité. L'invention concerne également un dispositif selon la revendication 5.

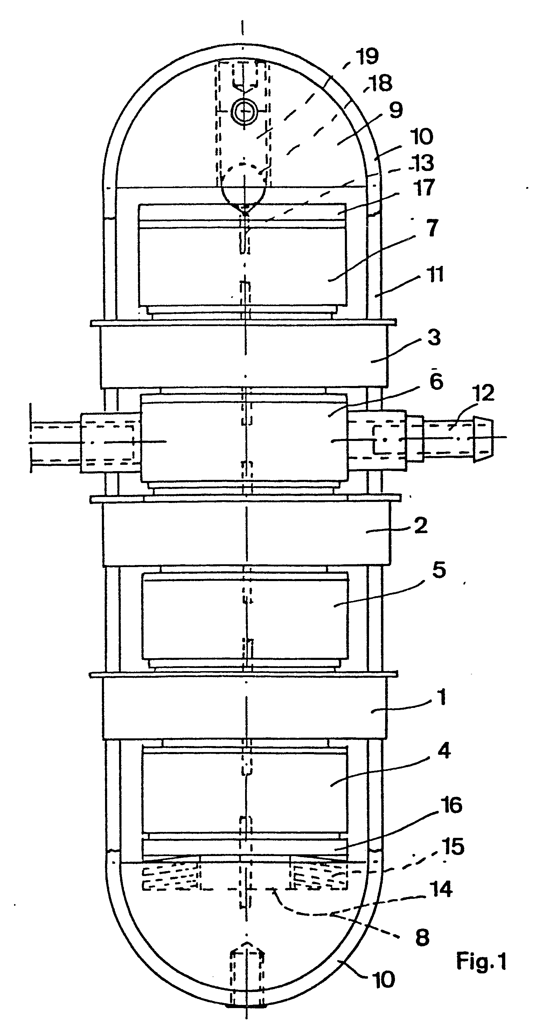

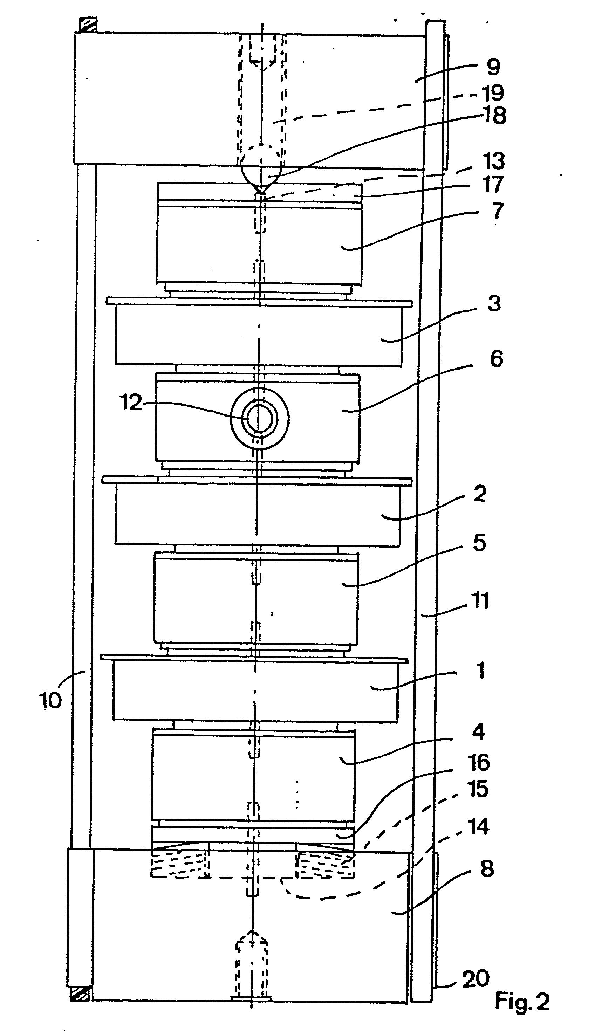

L'invention est expliquée ci-dessous par rapport à un exemple d'une forme d'exécution en se référant au dessin annexé. Les figures 1 et 2 du dessin sont deux vues perpendiculaires l'une par rapport à l'autre d'un même ensemble d'éléments électriques selon l'invention.

Aux figures 1 et 2, une colonne composée d'éléments électriques 1, 2, 3 et de masses refroidies 4, 5, 6, 7 est disposée entre deux pièces d'extrémité conformées en pièces de guidage 8, 9 réunies par une paire de courroies 10, 11 servant d'organes de liaison entre les pièces d'extrémité. Les éléments électriques 1, 2, 3 peuvent être notamment identiques entre eux ou peuvent être différents, par exemple des thyristors en série ou des thyristors en série avec des diodes, etc. Leur nombre n'est pas limité, ni celui des masses refroidies. Les masses 4, 5, 6, 7 peuvent être refroidies par air à l'aide d'ailettes, non représentées, ou à l'aide de conduits intérieurs, par un fluide réfrigérant approprié, soit liquide, soit gazeux. Pour simplifier le dessin, seul l'élément 6 est représenté avec des raccords 12 pour un fluide réfrigérant.

Pour assurer l'alignement axial des éléments électriques 1, 2, 3 avec les masses refroidies 4, 5, 6, des ergots de centrage 13 peuvent être disposés dans des logements correspondants prévus et dans les éléments 1, 2, 3 et dans les masses 4, 5, 6, 7, ainsi que dans la pièce de guidage 8.

Les pièces de guidage 8 et 9 sont de robustes masses semi-cylindriques ; elles sont équipées d'un ensemble élastique d'organes de serrage 15 à 19.

La pièce 8, disposée au bas de la colonne, est munie d'un logement 14 recevant un élément élastique 15, notamment un empilage de rondelles élastiques genre Belleville. L'empilage 15 est coiffé d'une plaque de répartition de pression 16 traversée par un trou axial pour laisser passer un ergot de centrage 13. Le dessus de la colonne est coiffé d'une plaque de répartition de pression 17 muni d'un alvéole recevant une bille 18 disposée au bout d'une vis de serrage 19 dont est équipée la pièce de guidage supérieure 9. Les deux pièces de guidage 8 et 9 sont réunies par une paire de courroies sans fin 10 et 11 dont, à la figure 2, la courroie 10 est coupée sur les crêtes des pièces de guidage 8 et 9 et dont, à la figure 1, la courroie 10 est coupée sur une partie où elle n'est pas en contact avec les pièces de guidage 8 et 9.

Les courroies 10 et 11 sont fabriquées sur un mandrin, non représenté, par exemple en enroulant sur ce mandrin plusieurs couches d'un ruban en fibres de verre préimprégnés et en polymérisant ces enroulements à couches multiples. De tels rubans en fibres de verre préimprégnés sont connus et utilisés notamment pour le frettage des têtes de bobines de bobinages de moteurs où leur résistance aux vibrations et leur bonne tenue au vieillissement ont été éprouvées.

Les courroies 10 et 11 peuvent être disposées soit sur la surface semi-cylindrique de la pièce de guidage comme c'est le cas pour la pièce de guidage 9, soit dans une gorge ou un épaulement 20 semi-cylindrique comme c'est le cas pour la pièce de guidage 8. Le serrage de la vis 19 dont est équipée la pièce de guidage 9 a pour effet de tendre les courroies 10 et 11 et de comprimer la colonne des éléments 1 à 7. La force de compression obtenue atteint toute valeur souhaitée ; elle dépend uniquement du dimensionnement des courroies et des organes de serrage, notamment de la vis 19 et des rondelles 15.

La fixation à un châssis, non représenté, peut se faire soit en vissant l'une ou l'autre pièce de guidage sur une partie conductrice ou isolante de ce châssis, soit aussi en fixant une des masses 4, 5, 6, 7 refroidies ou une plaque de répartition de pression 16, 17 par rapport à ce châssis.

Le fait que les courroies soient en un matériau isolant excellent permet de se contenter d'un encombrement minimum, non seulement en ce qui concerne l'encombrement géométrique de l'ensemble en soi, mais aussi l'encombrement du châssis de soutien dans lequel les distances d'isolement ne sont pas influencées par des tringles en matériau conducteur d'électricité. De plus, les courroies peuvent même passer dans des espaces libres entre des ailettes de refroidissement de masses refroidies.

**Revendications**

1. Procédé de fabrication d'un ensemble d'éléments électriques (1, 2, 3) enserrés entre des masses refroidies (4, 5, 6, 7) et alignés en colonne suivant un axe, selon lequel on comprime l'ensemble entre deux pièces d'extrémité (8, 9) débordant de ladite colonne, reliées entre elles par un organe de liaison en matière isolante à l'extérieur de la colonne et selon lequel on engendre une force de compression de la colonne au moyen d'un ensemble élastique d'organes de serrage (15 à 19) axiaux dont sont équipées les pièces d'extrémité, caractérisé en ce qu'on fabrique des courroies en matière isolante de longueurs sensiblement égales destinées à constituer l'organe de liaison, en ce qu'on relie entre elles les pièces d'extrémité au moyen d'une paire desdites courroies et en ce qu'on tend lesdites courroies en comprimant la colonne au moyen de l'ensemble élastique des organes de serrage équipant les pièces d'extrémité.

2. Procédé de fabrication suivant la revendication 1, caractérisé en ce qu'on équipe d'un élément élastique (15) la pièce d'extrémité (8) opposée à celle (9) comprenant une vis de serrage (19).

3. Procédé de fabrication suivant une des revendications précédentes, caractérisé en ce qu'on conforme chaque pièce d'extrémité en pièce de guidage (8, 9) présentant une surface, des gorges ou des épaulements de forme semi-cylindrique pour servir de guide et d'appui aux deux courroies (10, 11).

4. Procédé de fabrication suivant une des revendications précédentes, caractérisé en ce qu'on fabrique des courroies sans fin (10, 11) en matière isolante en enroulant sur un mandrin plusieurs couches d'un ruban de fibres de verre préimprégné et qu'on polymérise ces enroulements à couches multiples.

5. Ensemble d'éléments électriques (1, 2, 3) enserrés entre des masses refroidies (4, 5, 6, 7) et alignés en colonne selon un axe, ledit ensemble étant comprimé entre deux pièces d'extrémité débordant ladite colonne, reliées entre elles par un organe de liaison en matière isolante à l'extérieur de ladite colonne, la force de compression étant engendrée par un ensemble élastique d'organes de serrage (15 à 19) axiaux dont sont équipées les pièces d'extrémité (8, 9) caractérisé en ce que ledit organe de liaison est constitué de deux courroies (10, 11) tendues reliant les pièces d'extrémité (8, 9), la force de compression et la tension desdites courroies étant réglées par ledit ensemble élastique d'organes de serrage (15 à 19).

6. Ensemble suivant la revendication 5, caractérisé en ce que les pièces d'extrémité (8, 9) sont conformées en pièce de guidage présentant une surface, des gorges ou des épaulements de forme semi-cylindrique pour servir de guide et d'appui à deux courroies (10, 11) sans fin.

**Claims**

1. Method of producing an assembly of electrical elements (1, 2, 3) clamped between cooling members (4, 5, 6, 7) and axially aligned in a column formation, wherein the assembly is compressed between two end parts (8, 9) projecting from the said column and connected to one another by a connecting element made of insulating material externally of the column, and wherein the column is subjected to compressive force by means of an elastic assembly of axial clamping elements (15 to 19) with which the end parts are provided, characterised in that belts of insulating material are produced which are of substantially equal length and which are intended to constitute the connecting element, in that the end parts are connected together by means of a pair of the said belts and in that when the said belts are tensioned the column is compressed by means of the elastic assembly of clamping elements with which the end parts are provided.

2. Production method according to claim 1, characterised in that the end part (8) opposite from the end part (9) which has a clamping screw (19) is provided with an elastic element (15).

3. Production method according to one of the preceding claims, characterised in that each end part is formed as a guide part (8, 9) comprising a surface, grooves, or shoulders of semi-cylindrical form to serve as guiding and supporting means for the two belts (10, 11).

4. Production method according to one of the preceding claims, characterised in that endless belts (10, 11) made of insulating material are produced by winding on a mandrel a plurality of layers of a pre-impregnated glass fibre web, and polymerising these multi-layer wound packages.

5. Assembly of electrical elements (1, 2, 3) which are clamped between cooling members (4, 5, 6, 7) and are axially aligned in a column formation, the said assembly being compressed between two end parts which project from the said column and which are connected together by a connecting element made of insulating material externally of the said column, the compressive force being produced by an elastic assembly of axial clamping elements (15 to 19) provided on the end parts (8, 9), characterised in that the said connecting element is constituted by two tensioned belts (10, 11) connecting the end parts (8, 9), the compressive force and the tension of the said belts being regulated by the said elastic assembly of clamping elements (15 to 19).

6. Assembly according to claim 5, characterised in that the end parts (8, 9) are formed as guide parts comprising a surface, grooves, or shoulders of semi-cylindrical form for serving as guide and support means for two endless belts (10, 11).

**Ansprüche**

1. Verfahren zur Herstellung eines Zusammenbaues elektrischer Elemente (1, 2, 3), die zwischen Kühldosen (4, 5, 6, 7) eingespannt und gemäß einer Achse in Form einer Säule angeordnet sind, gemäß dem der Zusammenbau zwischen zwei Endstücken (8, 9) zusammengedrückt wird, die über die besagte Säule überstehen, und die außerhalb der Säule durch ein Verbindungselement aus Isoliermaterial miteinander verbunden sind, und gemäß dem mittels einer elastischen Einheit aus axialen Festziehvorrichtungen (15 bis 19), mit der die Endstücke ausgerüstet sind, eine Kraft zum Zusammendrücken der Säule erzeugt wird, dadurch gekennzeichnet, daß Riemen aus Isoliermaterial von ungefähr gleicher Länge hergestellt werden, die dazu bestimmt sind, das Verbindungselement zu bilden, daß die Endstücke mittels eines Paars der besagten Riemen miteinander verbunden werden, und daß die besagten Riemen gespannt werden, wozu die Säule mittels der elastischen Einheit aus den Festziehvorrichtungen, mit denen die Endstücke ausgerüstet ist, zusammengedrückt wird.

2. Herstellungsverfahren gemäß Anspruch 1, dadurch gekennzeichnet, daß das Endstück (8), das dem mit einer Festziehschraube (19) versehenen Endstück (9) gegenüberliegt, mit einem elastischen Element (15) ausgerüstet ist.

3. Herstellungsverfahren gemäß einem der vorhergehenden Ansprüche, dadurch gekennzeichnet, daß die beiden Endstücke als Führungsstücke (8, 9) ausgebildet sind, die eine Oberfläche, Rillen oder Schulterführungen von halbzylindrischer Form aufweisen, die den zwei Riemen (10, 11) als Führung und Auflage dienen.

4. Herstellungsverfahren gemäß einem der vorhergehenden Ansprüche, dadurch gekennzeichnet, daß Endlosriemen (10, 11) hergestellt werden, wozu mehrere Lagen eines vorimprägnierten Glasfaserbandes auf einen Dorn aufgewickelt werden, und diese mehrlagige Wicklung polymerisiert wird.

5. Zusammenbau aus elektrischen Elementen (1, 2, 3), die zwischen Kühldosen (4, 5, 6, 7) eingespannt und gemäß einer Achse in Form einer Säule angeordnet sind, wobei der besagte Zusammenbau zwischen zwei Endstücken zusammengedrückt wird, die über die besagte Säule überstehen und außerhalb der besagten Säule durch ein Verbindungselement aus Isoliermaterial miteinander verbunden sind, und die Kompressionskraft durch eine elastische Einheit aus axialen Festziehvorrichtungen (15 bis 19) erzeugt wird, mit der die Endstücke (8, 9) ausgerüstet ist, dadurch gekennzeichnet, daß das besagte Verbindungselement aus zwei gespannten Riemen (10, 11) besteht, die die Endstücke (8, 9) miteinander verbinden, wobei die Kompressionskraft und die Spannung der besagten Riemen durch die besagte elastische Einheit aus Festziehelementen (15 bis 19) eingestellt wird.

6. Zusammenbau gemäß Anspruch 5, dadurch gekennzeichnet, daß die Endstücke (8, 9) als Führungsteile ausgebildet sind, die eine Oberfläche, Rillen oder Schulterführungen von halbzylindrischer Form aufweisen, die zwei Endlosriemen (10, 11) als Führung und Auflage dienen.

Fig. 1

0 046 825

Fig. 2